# EUROPÄISCHE PATENTSCHRIFT

(11) **EP 1 372 262 B1**
(45) Veröffentlichungstag und Bekanntmachung des Hinweises auf die Patenterteilung: **26.12.2007**
(21) Anmeldenummer: 03006910.8
(22) Anmeldetag: 26.03.2003
(51) Int. Cl.: H03G 5/00

(54) **Verfahren zum Einstellen von Filterparametern und zugeordnetes Wiedergabesystem**
Method for adjusting filter parameters and associated reproducing apparatus
Procédé de réglage des paramètres de filtrage et appareil de reproduction associé

(30) Priorität: 06.06.2002 DE 10225146
(43) Veröffentlichungstag der Anmeldung: 17.12.2003
(73) Patentinhaber: ROBERT BOSCH GMBH, 70442 Stuttgart (DE)
(72) Erfinder: Montag, Christoph, 31134 Hildesheim (DE); Sahrhage, Joerg, 31139 Hildesheim (DE)

(56) Entgegenhaltungen:
- EP-A- 0 451 620
- DE-A- 10 027 618
- FR-A- 2 478 409
- US-A- 5 995 817

## Beschreibung

### Technisches Gebiet

Die vorliegende Erfindung betrifft ein Verfahren gemäß dem Oberbegriff des Anspruchs 1; bei diesem bekannten Verfahren wird unter Anderem der akustische Frequenzgang ermittelt (vgl. Druckschrift EP 0 451 620 A2).

Die vorliegende Erfindung betrifft des weiteren ein Wiedergabesystem gemäß dem Oberbegriff des Anspruchs 7.

### Stand der Technik

Die Erfindung geht von aus der Praxis bekannten Autoradiogeräten aus, die auf der sogenannten "2lC-Technologie basieren, bei der das Audio-Wiedergabegerät und insbesondere dessen Tuner mit einer insbesondere digitalen Empfängereinheit, beispielsweise mit einem "digital receiver" (sogenannter "digiceiver"), versehen ist. Dies bedeutet mit anderen Worten, dass bereits im Empfangsteil des Tuners das hochfrequente Signal der Z[wischen]F[requenz]-Stufe bei beispielsweise 10,7 Megahertz in Bits und Bytes umgesetzt wird und daran anschließend bis zu den Endstufen konsequent auf digitaler Ebene weiterverarbeitet wird.

Bei derartigen Autoradiogeräten sind beispielsweise zwei oder drei frei programmierbare Audiofilter in den Signalpfad integriert. Diese digitalen parametrischen Equalizer (= DPE) stehen dem Benutzer zur Verfügung, um Unzulänglichkeiten der Akustik im Fahrzeuginnenraum zu kompensieren. Der Benutzer kann jedes Filter in bezug auf bestimmte Filterparameter, wie etwa in bezug auf die Dämpfung, in bezug auf die Güte, das heißt die Filterbreite, in bezug auf die Mittenfrequenz und/oder in bezug auf die Verstärkung variieren, um Überhöhungen und sogenannte Löcher im akustischen Frequenzgang des Fahrzeuginnenraums auszugleichen.

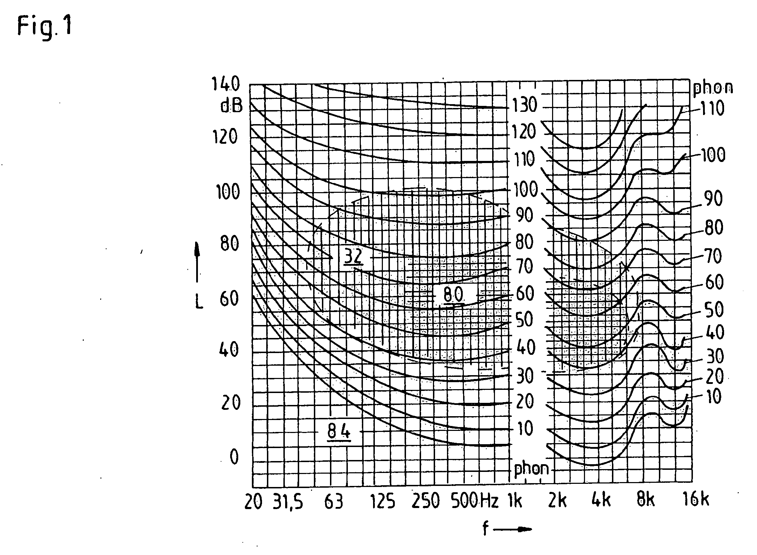

Im Zusammenhang mit dem akustischen Frequenzgang oder allgemeiner mit dem Lautstärkeempfinden des menschlichen Gehörs ist zu bedenken, daß dieses Lautstärkeempfinden über den hörbaren Frequenzbereich unterschiedlich ausgeprägt ist. Dies bedeutet mit anderen Worten, daß die Empfindlichkeit des menschlichen Gehörs nicht konstant über der Frequenz ist, sondern zu hohen Frequenzen und in noch stärkerem Maße zu niedrigen Frequenzen hin abnimmt. Dieser Effekt tritt mit sinkendem Schalldruckpegel verstärkt auf und wird, wie in Figur 1 dargestellt, in der Literatur durch Kurven gleicher Lautstärke (= sogenannte Isophonen) als Funktion des Schalldruckpegels L (in dB = Dezibel) über der Frequenz f (in Hz = Hertz) beschrieben (vgl. auch I[nternational]S[tandardization]O[rganization] 226).

Um zum Beispiel bei einer Audiofrequenz von einhundert Hertz den gleichen Lautstärkeeindruck wie bei einer Frequenz von einem Kilohertz zu erzielen, ist ein wesentlich höherer Schalldruck erforderlich. Dieser Zusammenhang wird durch die Darstellung der vorerwähnten Linien gleicher Lautheit in einem Schalldruck/Frequenz-Diagramm dargestellt (vgl. Figur 1, in der der Sprachbereich durch das Bezugszeichen 80, der Musikbereich durch das Bezugszeichen 82 und der Bereich der Hörschwelle durch das Bezugszeichen 84 kenntlich gemacht sind).

Zum Kompensieren dieses Effekts verfügen Systeme zum Wiedergeben von Audiosignalen häufig über eine Vorrichtung zum selektiven Anheben des Pegels der Bässe bei niedriger Wiedergabelautstärke; bei manchen Systemen werden die Höhen ebenfalls ein wenig angehoben. Diese als "gehörrichtige Lautstärkekorrektur" oder "Loudness Control" bezeichnete Vorrichtung soll die vom Zuhörer wahrgenommene Lautheit des Audiosignals unabhängig von der Wiedergabelautstärke über das ganze Hörfrequenzspektrum konstant halten, das heißt ein spektral ausgewogenes Klangbild gewährleisten.

Um also in einem Audiowiedergabesystem zu gewährleisten, daß der Klangeindruck, wie etwa die Ausgewogenheit zwischen tiefen Frequenzanteilen und mittleren Frequenzanteilen, bei allen Abhörlautstärken gleichbleibt, ist in vielen Systemen eine sogenannte Loudness-Funktion implementiert.

Diese Loudness-Funktion verändert im Zusammenhang mit der Lautstärke auch die Klangeinstellung in der Art, daß alle Frequenzanteile als gleich laut empfunden werden; insbesondere werden in einer einfachen Ausführungsform bei reduzierter Lautstärke die tiefen Frequenzanteile unterhalb einer bestimmten Einsatzfrequenz mithilfe eines Klangstellers angehoben, was den Hauptanteil einer gehörrichtigen Korrektur des Frequenzgangs ausmacht. Diese Einsatzfrequenz ist in jedem Audiowiedergabesystem entweder werkseitig festgelegt oder kann vom Benutzer innerhalb bestimmter Grenzen manuell eingestellt werden.

Allerdings stellt bei den bekannten Loudness-Funktionen die Wahl der optimalen Einsatzfrequenz der Baßpegelanhebung ein Problem dar. Da nämlich die Empfindlichkeit des menschlichen Gehörs zu tiefen Frequenzen hin stark abnimmt, ist üblicherweise eine Baßpegelanhebung bis zu extrem tiefen Frequenzen hin erforderlich, um eine gehörrichtige Korrektur vorzunehmen.

Dies ist jedoch nicht in allen Audiowiedergabesystemen sinnvoll, denn die Performance bestimmter Verstärker und/oder bestimmter Lautsprecher erlaubt die Wiedergabe sehr tiefer Frequenzen potentiellerweise nicht. Die zunehmende Anhebung zu sehr tiefen Frequenzen hin wäre also akustisch wirkungslos bzw. würde unter Umständen zum Übersteuern der Verstärkerstufen bzw. der Lautsprecher führen.

Für solche Systeme ist die Wahl einer höheren Einsatzfrequenz bzw. eine Begrenzung der Anhebung zu tiefen Frequenzen hin sinnvoll, um zumindest eine gehörrichtige Korrektur für den oberen Baßfrequenzbereich vorzunehmen und um das Wiedergabesystem nicht zu überlasten. Ist nun die Performance der Verstärkerstufen bzw. der Lautsprecher dem für die Loudness verantwortlichen Steuerungsgerät nicht bekannt, wie es typischerweise in einem einen sogenannten "Autoradio-Booster-Lautsprecher" aufweisenden System der Fall ist, so kann die Einstellung der Charakteristik der Loudness werksseitig nicht immer optimal sein.

Eine manuelle Einstellung der Charakteristik der Loudness durch den Benutzer erfordert hingegen einiges akustisches und technisches Know-How; insbesondere erweist sich eine derartige manuelle Einstellung in der Praxis insofern als problematisch, als der Benutzer die Akustik seines Fortbewegungsmittels für eine optimale Einstellung der Equalizer sehr gut kennen muß und als das Ermitteln des akustischen Frequenzgangs ohne meßtechnische Hilfe, das heißt allein durch Hören sehr schwierig ist.

Die Bedienungsanleitungen bekannter Autoradiogeräte können nur sehr eingeschränkte Hilfestellungen für die bestmögliche Einstellung der Equalizer geben, denn in diesen Bedienungsanleitungen können keinesfalls alle Fahrzeugtypen und schon gar nicht die Vielzahl der individuellen Ausstattungsvarianten sowie der Verstärker- und Lautsprecherkonfigurationen berücksichtigt werden.

Des weiteren sind Autoradiogeräte mit einem in den Signalpfad integrierten Audiomodul bekannt, auf dem mithilfe eines digitalen Signalprozessors ein graphischer Equalizer realisiert ist. Die sieben bzw. neun Bänder eines solchen graphischen Equalizers sind in ihrer Mittenfrequenz fest und nur in ihrer Verstärkung veränderbar. Das separate Audiomodul dieser Autoradiogeräte ermöglicht ein automatisches Einmessen des graphischen Equalizers.

Hierzu wird die Akustik im Fahrzeuginnenraum mithilfe eines Mikrophons gemessen, das über einen A[nalog]/D[igital]-Wandler an das Audiomodul angeschlossen ist. Mithilfe einer speziellen Software wird der graphische Equalizer anschließend so eingestellt, daß die Unzulänglichkeiten der Akustik so gut wie möglich ausgeglichen werden.

Der Einsatz eines graphischen Equalizers zum Optimieren der gehörrichtigen Baßpegelanhebung erweist sich in bezug auf die Akustik eines Fahrzeuginnenraums in der Praxis als problematisch. Wie bereits erwähnt, sind die Mittenfrequenzen der Equalizerbänder eines graphischen Equalizers fix; sie liegen in der Regel in einem Abstand von minimal einer Oktave bei neun Bändern. Schmale Resonanzüberhöhungen im akustischen Frequenzgang des Fahrzeuginnenraums, die zwischen den Equalizerbändern liegen, können so nicht optimal kompensiert werden. Außerdem ist das zusätzliche Audiomodul mit dem digitalen Signalprozessor zur Realisierung des graphischen Equalizers und zum Einmessen dieses Equalizers relativ kostenintensiv.

### Darstellung der Erfindung: Aufgabe, Lösung, Vorteile

Ausgehend von den vorstehend dargelegten Nachteilen und Unzulänglichkeiten sowie unter Würdigung des umrissenen Standes der Technik liegt der vorliegenden Erfindung die Aufgabe zugrunde, ein Verfahren der eingangs genannten Art sowie ein Wiedergabesystem der eingangs genannten Art so weiterzuentwickeln, daß eine automatische Optimierung einer gehörrichtigen Baßpegelanhebung erfolgt.

Diese Aufgabe wird gemäß der Lehre der vorliegenden Erfindung durch ein Verfahren mit den im Anspruch 1 genannten Merkmalen sowie durch ein Wiedergabesystem mit den im Anspruch 7 genannten Merkmalen gelöst. Vorteilhafte Ausgestaltungen und zweckmäßige Weiterbildungen der vorliegenden Erfindung sind in den jeweiligen Unteransprüchen gekennzeichnet.

Mithin ist der Kern der vorliegenden Erfindung darin zu sehen, daß die sogenannte Loudness des Audiowiedergabesystems automatisch optimiert wird; dies geht verfahrensgemäß einher mit einer automatischen Optimierung der gehörrichtigen Baßpegelanhebung auf das Wiedergabesystem und wird mittels eines Einmeßverfahrens realisiert, das den Wirkungsgrad des Audiowiedergabesystems abhängig von der Audiofrequenz ermittelt und so die Charakteristik der Loudness auf das Wiedergabesystem hin optimiert, so daß in Abhängigkeit von der Performance des Wiedergabesystems die bestmögliche Korrektur des Frequenzgangs vorgenommen werden kann.

Dies wird erfindungsgemäß erreicht durch ein Verfahren zum automatischen Optimieren der gehörrichtigen Baßpegelanhebung auf das Audiowiedergabesystem, bei dem
- zunächst der akustische Frequenzgang des Fahrzeuginnenraums ermittelt wird,
- dann eine Grenzfrequenz bestimmt wird, unterhalb derer der Schalldruck einen auf den mittleren Schalldruck bezogenen Schalldruckschwellwert unterschreitet, und
- im Anschluß daran der bzw. die Filterparameter der Filtereinheit automatisch so eingestellt wird bzw. werden, daß die Mittenfrequenz der Filtereinheit gerade oberhalb der bestimmten Grenzfrequenz liegt.

Mit der vorliegenden Erfindung wird dem Benutzer also die schwierige Aufgabe der Anpassung der Filtereinheit(en) an die spezielle Akustik seines Fahrzeuginnenraums abgenommen. In diesem Zusammenhang ermöglicht das Messen des Amplitudengangs und/oder des Frequenzgangs nicht nur das Einstellen von n-1 Equalizerfiltern, sondern - gewissermaßen als für den Fachmann überraschendes, so nicht vorhersehbares Nebenprodukt - auch das Einstellen eines Loudness-Filters im unteren Frequenzbereich, sofern die Anordnung von exemplarisch insgesamt n rekursiven Filtern zweiter Ordnung im Wiedergabesystem unterstellt wird. In diesem Zusammenhang stellt das Loudness-Filter eines der Resonanzfilter, allgemeiner gesprochen eines der n rekursiven Filter zweiter Ordnung dar (unter gewissen Bedingungen kann das rekursive Filter auch als Shelving-Filter ausgebildet sein, dies ist im Falle der vorliegenden Erfindung jedoch nicht der Normalfall).

Im Detail wird zunächst der Frequenzgang des vorliegenden Audiowiedergabesystems mithilfe geeigneter Vorkehrungen ermittelt. Im Anschluß wird der gemessene Frequenzgang hinsichtlich des Wirkungsgrads des Wiedergabesystems im tieffrequenten Bereich ausgewertet.

Aus dem gemessenen Frequenzgang kann zunächst der mittlere Schalldruck ermittelt werden. Im Anschluß daran wird der Frequenzpunkt im tieffrequenten Bereich ermittelt, unterhalb dessen der Schalldruck einen bestimmten, auf den mittleren Schalldruck bezogenen Grenzwert unterschreitet, zum Beispiel etwa drei Dezibel. Ein Loudness-Filter oder Resonanzfilter wird nun genau so eingestellt, daß die Mittenfrequenz gerade oberhalb dieser Grenzfrequenz des Audiosystems liegt.

Auf diese Weise wird einerseits sichergestellt, daß die Baßanhebung auch akustisch wirksam ist, andererseits wird das System nicht überlastet, denn der Frequenzgang des Loudness-Filters oder Resonanzfilters fällt unterhalb der Mittenfrequenz wieder ab. Im Ergebnis beruht das Verfahren in erfindungswesentlicher Weise also darauf, daß einer der digitalen Equalizer der Loudness-Funktionalität, das heißt der Überprüfung auf einen Abfall um beispielsweise etwa drei Dezibel zugeordnet wird.

Des weiteren wird ein Wiedergabesystem der eingangs genannten Art vorgeschlagen, das zum automatischen Einstellen der mindestens einen Filtereinheit erfindungsgemäß einen Rauschgenerator umfaßt, über den sich dem der Filtereinheit zugeordneten Equalizer ein Rauschsignal zuführen läßt.

Außerdem weist der Steuerungsprozessor Mittel auf, über die die Filterparameter so einstellbar sind, daß der Equalizer eine Bandpaßcharakteristik mit schmaler Bandbreite aufweist, wobei die Mittenfrequenz über dem Audiospektrum variierbar ist.

Zum Erfassen des von der Lautsprechereinrichtung in den Fahrzeuginnenraum abgestrahlten Signals und zum Bestimmen des Frequenzgangs ist mindestens ein Mikrophon mit Auswertemitteln vorgesehen.

Schließlich weist der Steuerungsprozessor noch Mittel auf, über die die Filterparameter unter Berücksichtigung des gemessenen Frequenzgangs einstellbar sind.

Erfindungsgemäß ist erkannt worden, daß die einzumessenden Equalizer aufgrund ihrer Programmierbarkeit zunächst zur Bestimmung des akustischen Frequenzgangs des Fahrzeuginnenraums verwendet werden können, bevor eine Grenzfrequenz bestimmt wird, unterhalb derer der Schalldruck einen auf den mittleren Schalldruck bezogenen Schalldruckschwellwert unterschreitet, und sodann der bzw. die Filterparameter der Filtereinheit automatisch so eingestellt wird bzw. werden, daß die Mittenfrequenz der Filtereinheit gerade oberhalb der bestimmten Grenzfrequenz liegt.

Das Merkmal, daß der bzw. die Filterparameter der Filtereinheit automatisch so eingestellt wird bzw. werden, daß die Mittenfrequenz der Filtereinheit gerade oberhalb der bestimmten Grenzfrequenz liegt, kann in erfindungswesentlicher Weise mit dem Merkmal verknüpft werden, daß die Baßpegelanhebung mit steigender Grenzfrequenz bzw. mit steigender Mittenfrequenz der Filtereinheit derart reduziert wird, daß die Isophonen im verbleibenden wiedergebbaren Baßfrequenzbereich nicht überschritten werden (--> funktioneller Zusammenhang zwischen der Filtermitten-/grenzfrequenz sowie der eingestellten Lautstärke als Eingangsgrößen und der resultierenden Baßanhebung als Ausgangsgröße; dieser funktionelle Zusammenhang erfolgt über eine mathematische Funktion und kann, abhängig von den jeweiligen Gegebenheiten, in erfindungswesentlicher Weise kontinuierlich oder in Stufen erfolgen; im Ergebnis erfolgt also eine automatische Optimierung einer gehörrichtigen Baßpegelanhebung, indem die Filterparameter der Baßanhebungsfiltereinheit in Abhängigkeit von oder als Funktion der Grenzfrequenz bzw. der Mittenfrequenz eingestellt werden).

Hierdurch wird in synergetischer Weise zum einen eine automatische Optimierung der gehörrichtigen Baßpegelanhebung erfolgen, zum anderen kann jedoch gleichwohl eine übermäßige Baßpegelanhebung vermieden werden. Ferner ist erfindungsgemäß erkannt worden, daß die Optimierung der gehörrichtigen Baßpegelanhebung mithilfe einer entsprechenden Zusatzsoftware vom ohnehin vorhandenen Steuerungsprozessor des Autoradiogeräts vorgenommen werden kann.

Im Ergebnis ist also im Rahmen der vorliegenden Erfindung kein zusätzliches Audiomodul mit digitalem Signalprozessor erforderlich, sondern lediglich eine Mikrophon-, Verstärkungs- und Gleichrichtungsschaltung, die an die im Steuerungsprozessor vorhandene A[nalog]/D[igital]-Wandlereinheit angekoppelt wird; hierdurch ist für die erfindungsgemäß vorgeschlagene automatische Einstellung der Filterparameter in bezug auf die Mittenfrequenz lediglich ein sehr geringer Mehraufwand an Hardware sowie an Software und mithin an Kosten erforderlich.

Grundsätzlich gibt es verschiedene Möglichkeiten für die Ermittlung des akustischen Frequenzgangs des Fahrzeuginnenraums im Rahmen des vorliegenden Verfahrens. Gemäß einer vorteilhaften Ausgestaltungsform wird die Lautsprechereinrichtung des Wiedergabesystems nacheinander von Bandpaß-Rauschsignalen mit unterschiedlichen Mittenfrequenzen angesteuert. Die jeweils in Form eines Bandpaß-Rauschsignals eingestellten Frequenzbänder decken das gesamte Audiospektrum ab.

Der zu ermittelnde Frequenzgang wird nun in Form von Frequenzmeßpunkten für die einzelnen Frequenzbänder ermittelt. Als Frequenzmeßpunkt für ein bestimmtes Frequenzband kann einfach der Schallpegel des Signals bestimmt werden, das in diesem Fall von der Lautsprechereinrichtung in den Fahrzeuginnenraum abgestrahlt wird.

Im Hinblick auf eine Minimierung des Hardware-Aufwands sowie des Software-Aufwands erweist es sich als vorteilhaft, die Bandpaß-Rauschsignale zum Ermitteln des akustischen Frequenzgangs des Fahrzeuginnenraums mithilfe des einzustellenden Equalizers selbst zu erzeugen.

Da dieser sowohl in seiner Mittenfrequenz als auch in seiner Güte frei programmierbar ist, können die Filterparameter so eingestellt werden, daß sich für den Equalizer eine Bandpaßcharakteristik mit schmaler Bandbreite bei vorgegebener Mittenfrequenz ergibt. Der Equalizer erzeugt dann aus einem ihm zugeführten Rauschsignal das gewünschte Bandpaß-Rauschsignal bzw. eine Abfolge von Bandpaß-Rauschsignalen, die das gesamte Audiospektrum abdecken.

Werden die Filterparameter von mehreren digitalen Equalizern automatisch eingestellt, so ist es von Vorteil, die Filterparameter der einzelnen Equalizer nacheinander zu bestimmen, indem jeweils vor dem Bestimmen der Filterparameter eines Equalizers der bzw. die vorher eingestellten Equalizer auf den gemessenen Frequenzgang angewendet werden.

Die vorliegende Erfindung betrifft schließlich die Verwendung des Verfahrens gemäß der vorstehend dargelegten Art und/oder des Wiedergabesystems gemäß der vorstehend dargelegten Art für Audiosignale in mindestens einem Fortbewegungsmittel, insbesondere im Innenraum mindestens eines Kraftfahrzeugs.

### Kurze Beschreibung der Zeichnungen

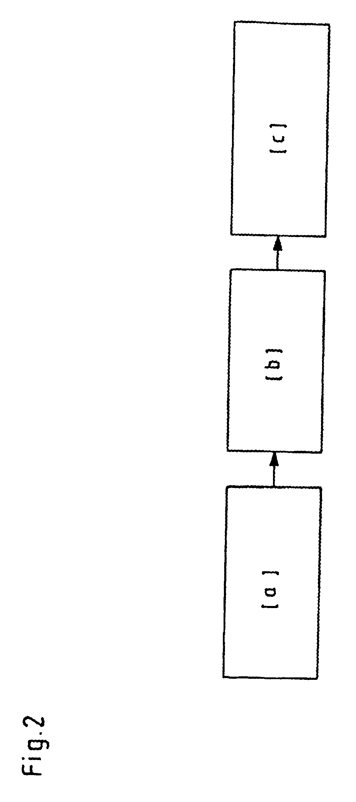

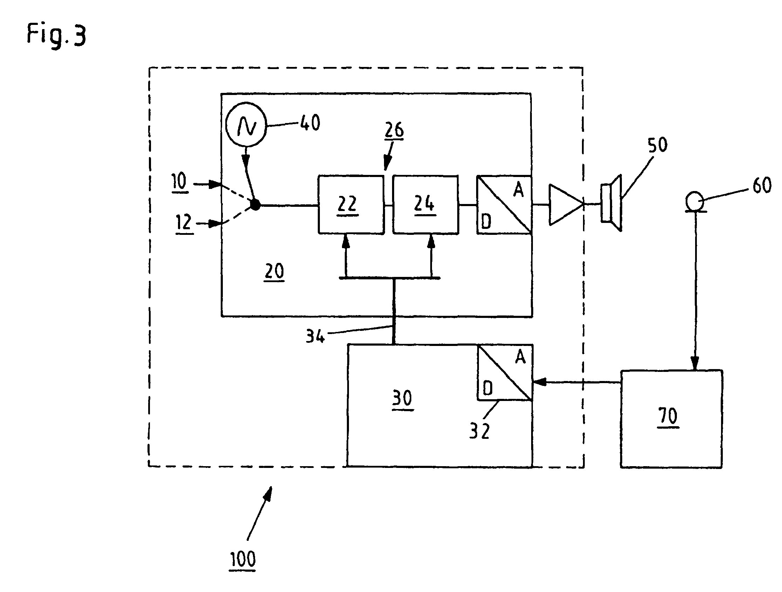

Wie bereits voranstehend ausführlich erörtert, gibt es verschiedene Möglichkeiten, die Lehre der vorliegenden Erfindung in vorteilhafter Weise auszugestalten und weiterzubilden. Hierzu wird einerseits auf die den Ansprüchen 1 und 7 nachgeordneten Ansprüche verwiesen, andererseits werden weitere Ausgestaltungen, Merkmale und Vorteile der vorliegenden Erfindung nachstehend anhand des durch die Figuren 2 und 3 veranschaulichten Ausführungsbeispiels näher erläutert.

Es zeigt:
- Fig. 1: ein gemäß l[nternational]S[tandardization]O[rganization] normiertes Diagramm für Kurven gleicher Lautstärke (= sogenannte Isophonen), die als Funktion des Schallpegeldrucks über der Frequenz aufgetragen sind;
- Fig. 2: ein schematisches Blockschaltbild (= Ablaufdiagramm) eines Ausführungsbeispiels für ein Verfahren gemäß der vorliegenden Erfindung; und
- Fig. 3: eine schematische Prinzipdarstellung (= Blockdiagramm) eines Ausführungsbeispiels für ein Wiedergabesystem gemäß der vorliegenden Erfindung, das zum Durchführen des Verfahrens gemäß Fig. 2 vorgesehen ist.

### Bester Weg zur Ausführung der Erfindung

In Figur 2 ist das Funktionsprinzip eines anhand Figur 3 veranschaulichten Wiedergabesystems 100 gemäß der vorliegenden Erfindung skizziert.

Das in Figur 3 dargestellte Audiowiedergabesystem 100 dient der Wiedergabe von Audiosignalen in einem Fahrzeuginnenraum, wobei die Audiosignale von unterschiedlichen Audioquellen 10, 12, wie zum Beispiel von einer C[ompact]D[isc], von einem Radio oder von dergleichen, generiert werden können.

Das Wiedergabesystem 100 weist eine Lautsprechereinrichtung 50 und einen im Signalpfad zwischen den Audioquellen 10, 12 und der Lautsprechereinrichtung 50 angeordneten Audioprozessor 20 mit zwei frei einstellbaren digitalen Equalizern 22, 24 auf, über die die Signale der unterschiedlichen Audioquellen 10, 12 der Lautsprechereinrichtung 50 zugeführt werden; selbstverständlich können hier auch mehr als zwei Equalizer 22, 24 vorgesehen sein. Zum Einstellen der Filterparameter, insbesondere zum Einstellen der Mittenfrequenz, sendet ein Steuerungsprozessor 30 über einen Steuerungsbus 34 geeignete Filterparameter an den Audioprozessor 20.

Zum Bestimmen bzw. zum Messen des Frequenzgangs des vorliegenden Audiosystems im Fahrzeuginnenraum (= Verfahrensschritt [a] gemäß Figur 2) weist das Wiedergabesystem 100 ferner einen Rauschgenerator 40 auf, über den den Equalizern 22, 24 ein Rauschsignal zugeführt werden kann. Der Rauschgenerator 40 ist hier als Zusatzsoftware im Audioprozessor 20 implementiert und kann bei Bedarf über den Steuerungsprozessor 30 gestartet werden.

Alternativ hierzu kann das Rauschsignal auch von einer externen Rauschquelle als zusätzlicher Audioquelle erzeugt werden, zum Beispiel mithilfe einer entsprechenden C[ompact]D[isc] oder mithilfe eines in geeigneter Weise eingestellten Tuners.

Des weiteren weist der Steuerungsprozessor 30 Mittel auf, über die die Filterparameter so eingestellt werden können, daß die Equalizer 22, 24 eine Bandpaßcharakteristik mit schmaler Bandbreite, das heißt mit einer Güte der Größenordnung 8, aufweisen, wobei die Mittenfrequenz über dem Audiospektrum variierbar ist. Auf diese Weise kann die Lautsprechereinrichtung 50 mithilfe des Rauschgenerators 40 und über die Equalizer 22, 24 mit einem Bandpaß-Rauschsignal angesteuert werden.

Wenn das Einmessen der Equalizer 22, 24 beispielsweise durch Tastendruck gestartet worden ist, variiert der Steuerungsprozessor 30 die Filterparameter in definierter zeitlicher Abfolge so, daß die Mittenfrequenz des Bandpaßfilters zum Beispiel im Terzabstand von der höchsten einzustellenden Frequenz bis zur tiefsten einzustellenden Frequenz abnimmt.

Die Signale, die dann jeweils über die Lautsprechereinrichtung 50 in den Fahrzeuginnenraum abgestrahlt werden, werden mithilfe eines Mikrophons 60 erfaßt und mit geeigneten Auswertemitteln 70 zum Bestimmen des Frequenzgangs des Fahrzeuginnenraums ausgewertet.

Hierzu werden die vom Mikrophon 60 erfaßten Signale in einer Operationsverstärkerschaltung verstärkt, logarithmiert und gleichgerichtet, so daß am Ausgang dieser Schaltung eine Gleichspannung anliegt. Die Größe dieser Gleichspannung ist proportional zum Schallpegel bzw. zum Schalldruck im Fahrzeuginnenraum für das Frequenzband, das durch das jeweilige Bandpaß-Rauschsignal eingestellt ist. Durch das Durchstimmen der Equalizer 22, 24 wird der Schallpegel für das gesamte Audiospektrum detektiert.

Die den Schallpegel repräsentierende Gleichspannung wird von einem A[nalog]/D[igital]-Wandler 32 des Steuerungsprozessors 30 abgetastet, so daß dem Steuerungsprozessor 30 nach dem Durchstimmen aller zu messenden Frequenzen bzw. Frequenzbänder mit den entsprechenden Spannungswerten ein genaues Abbild des akustischen Frequenzgangs des Fahrzeuginnenraums vorliegt. Als Frequenzgang wird hier ausschließlich der Betragsfrequenzgang bzw. der Amplitudengang bezeichnet und nicht der Phasengang.

Im Steuerungsprozessor 30 wird nun in einem zweiten Verfahrensschritt [b] (vgl. Figur 2) eine untere Grenzfrequenz bestimmt, unterhalb derer der Schalldruck einen auf den mittleren Schalldruck bezogenen Schalldruckschwellwert unterschreitet. In einem abschließenden Verfahrensschritt [c] (vgl. Figur 2) wird dann die Mittenfrequenz des Loudness-Filters 26 (= Resonanzfilter) automatisch festgelegt, so daß im Ergebnis eine automatische Optimierung einer gehörrichtigen Baßpegelanhebung erfolgt ist.

Mit der vorliegenden Erfindung gemäß den Figuren 2 und 3 wird dem Benutzer also die schwierige Aufgabe der Anpassung der Filtereinheit 26 an die spezielle Akustik seines Fahrzeuginnenraums abgenommen. In diesem Zusammenhang ermöglicht das Messen des Amplitudengangs bzw. des Frequenzgangs nicht nur das Einstellen der beiden Equalizerfilter 22, 24, sondern auch das Einstellen des Loudness-Filters 26 im unteren Frequenzbereich (in diesem Zusammenhang stellt das Loudness-Filter 26 eines der Resonanzfilter, allgemeiner gesprochen eines der rekursiven Filter zweiter Ordnung dar). Im Ergebnis beruht das Verfahren gemäß Figur 2 also darauf, daß einer der digitalen Equalizer 22, 24 in Figur 3 der Loudness-Funktionalität, das heißt der Überprüfung auf einen Abfall um beispielsweise etwa drei Dezibel zugeordnet wird.

In erfindungswesentlicher Weise kann das Merkmal, daß der bzw. die Filterparameter des Loudness-Filters 26 automatisch so eingestellt wird bzw. werden, daß die Mittenfrequenz des Loudness-Filters 26 gerade oberhalb der bestimmten Grenzfrequenz liegt, mit dem Merkmal verknüpft werden, daß die Baßpegelanhebung mit steigender Grenzfrequenz bzw. mit steigender Mittenfrequenz des Loudness-Filters 26 derart reduziert wird, daß die Isophonen im verbleibenden wiedergebbaren Baßfrequenzbereich nicht überschritten werden; hierdurch erfolgt in synergetischer Weise zum einen eine automatische Optimierung der gehörrichtigen Baßpegelanhebung, zum anderen wird jedoch gleichwohl eine übermäßige Baßpegelanhebung vermieden.

Der gesamte Zusatzaufwand gegenüber einem Autoradiogerät, dessen Equalizer nicht automatisch einstellbar sind, besteht in einer Zusatzhardware 40 bzw. in einer Zusatzsoftware zum Generieren eines Rauschsignals, in einer Zusatzsoftware im Steuerungsprozessor 30, die die Ablaufsteuerung des Einmeßvorgangs (= Verfahrensschritt [a]; vgl. Figur 2) sowie die Ermittlung der besten Filterparametereinstellung(en) übernimmt, und in einer Zusatzhardware 70 für die Verstärkung, Logarithmierung und Gleichrichtung der Signale des Mikrophons 60.

Zum Ermitteln der bestmöglichen Einstellung der Filterparameter können im Audioprozessor 20 auch normierte Equalizer-Musterkurven mit unterschiedlicher Güte abgespeichert sein.

Abschließend sei noch angemerkt, daß die vorbeschriebene automatische Loudness-Optimierung gut am Audiowiedergabesystem 100 nachweisbar ist, denn zum einen muß eine Frequenzgangmessung vom Benutzer aktivierbar sein (--> Bedienungsanleitung), und zum anderen kann die Optimierung durch Messen der Loudness-Kurven nach Frequenzgangmessungen in verschiedenen Audiosystemen nachgewiesen werden.

## Patentansprüche

1. Verfahren zum Einstellen zumindest der Mittenfrequenz mindestens einer einem Wiedergabesystem (100) für Audiosignale zugeordneten Filtereinheit (26), insbesondere rekursiven Filtereinheit zweiter Ordnung oder Resonanzfiltereinheit, die insbesondere mindestens einem dem Wiedergabesystem (100) zugeordneten digitalen Equalizer (22, 24) zugeordnet wird, bei welchem Verfahren
[a] zunächst der akustische Frequenzgang ermittelt wird,
**dadurch gekennzeichnet,**
[b] **dass** dann eine Grenzfrequenz für die Basspegelanhebung bestimmt wird, unterhalb derer der Schalldruck einen auf den mittleren Schalldruck bezogenen Schalldruckschwellwert unterschreitet, und
[c] **dass** dann mindestens ein Filterparameter der Filtereinheit (26) automatisch so eingestellt wird, dass die Mittenfrequenz der Filtereinheit (26) gerade oberhalb der bestimmten Grenzfrequenz liegt.

2. Verfahren gemäß Anspruch 1, **dadurch gekennzeichnet, dass** der akustische Frequenzgang ermittelt wird, indem
- mindestens eine Lautsprechereinrichtung (50) des Wiedergabesystems (100) nacheinander von Bandpass-Rauschsignalen mit unterschiedlichen Mittenfrequenzen angesteuert wird, wobei die jeweils in Form mindestens eines Bandpass-Rauschsignals eingestellten Frequenzbänder das gesamte Audiospektrum abdecken, und
- der Frequenzgang in Form von Frequenzmesspunkten für die einzelnen Frequenzbänder ermittelt wird, wobei als Frequenzmesspunkt für ein bestimmtes Frequenzband der Schallpegel des Signals bestimmt wird, das in diesem Fall von der Lautsprechereinrichtung (50) abgestrahlt wird.

3. Verfahren gemäß Anspruch 2, **dadurch gekennzeichnet, dass** die Bandpass-Rauschsignale zum Ermitteln des akustischen Frequenzgangs mittels des Equalizers (22, 24) erzeugt werden, indem
- dem Equalizer (22, 24) mindestens ein Rauschsignal zugeführt wird und
- der bzw. die Filterparameter der Filtereinheit (26) so eingestellt wird bzw. werden, dass sich für den Equalizer (22, 24) eine Bandpasscharakteristik mit schmaler Bandbreite bei vorgegebener Mittenfrequenz ergibt.

4. Verfahren gemäß mindestens einem der Ansprüche 1 bis 3, **dadurch gekennzeichnet, dass** zwischen dem Verfahrensschritt [a] des Ermittelns des akustischen Frequenzgangs und dem Verfahrensschritt [b] des Bestimmens der Grenzfrequenz der mittlere Schalldruck ermittelt wird.

5. Verfahren gemäß mindestens einem der Ansprüche 1 bis 4, **dadurch gekennzeichnet, dass** vor dem, während des oder nach dem Verfahrensschritt [c] der bzw. die Filterparameter der Filtereinheit (26) so eingestellt wird bzw. werden, dass die Basspegelanhebung mit steigender Grenzfrequenz bzw. mit steigender Mittenfrequenz der Filtereinheit (26) derart reduziert wird, dass die Isophonen im verbleibenden wiedergebbaren Bassfrequenzbereich nicht überschritten werden.

6. Verfahren gemäß mindestens einem der Ansprüche 1 bis 5, wobei der bzw. die Filterparameter mittels mindestens zweier digitaler Equalizer (22, 24) automatisch eingestellt wird bzw. werden, **dadurch gekennzeichnet, dass** die Filterparameter der einzelnen Equalizer (22, 24) nacheinander bestimmt werden, indem jeweils vor der Bestimmung der Filterparameter eines Equalizers (22, 24) der bzw. die vorher eingestellten Equalizer (22, 24) auf den ermittelten Frequenzgang angewendet werden.

7. Wiedergabesystem (100) für Audiosignale, mittels dessen ein Verfahren gemäß mindestens einem der Ansprüche 1 bis 6 durch Einstellen zumindest der Mittenfrequenz mindestens einer mindestens einem digitalen Equalizer (22, 24) des Wiedergabesystems (100) zugeordneten Filtereinheit (26) durchführbar ist,
- mit mindestens einer Lautsprechereinrichtung (50) und
- mit mindestens einem den Equalizer (22, 24) aufweisenden Audioprozessor (20), der
-- im Signalpfad zwischen mindestens einer Signalquelle (10, 12) und der Lautsprechereinrichtung (50) angeordnet ist und
-- über mindestens einen Steuerungsbus (34) mit mindestens einem Steuerungsprozessor (30) verbunden ist,
**dadurch gekennzeichnet,**
- **dass** mindestens ein Rauschgenerator (40) vorgesehen ist, über den dem Equalizer (22, 24) mindestens ein Rauschsignal zuführbar ist,
- **dass** der Steuerungsprozessor (30) Mittel aufweist, über die mindestens ein Filterparameter der Filtereinheit (26) so eingestellt wird, dass der Equalizer (22, 24) eine Bandpasscharakteristik mit schmaler Bandbreite aufweist, wobei die Mittenfrequenz über dem Audiospektrum variierbar ist,
- **dass** mindestens ein Mikrophon (60) mit Auswertemitteln (70) zum Erfassen des von der Lautsprechereinrichtung (40) abgestrahlten Signals und zum Bestimmen des Frequenzgangs vorgesehen ist und
- **dass** der Steuerungsprozessor (30) Mittel aufweist, mittels der der mindestens eine Filterparameter unter Berücksichtigung des gemessenen Frequenzgangs eingestellt wird.

8. Wiedergabesystem gemäß Anspruch 7, **dadurch gekennzeichnet, dass** der Rauschgenerator (40)
- im Audioprozessor (20) implementiert und/oder
- in Form einer zusätzlichen externen Signalquelle realisiert ist.

9. Wiedergabesystem gemäß Anspruch 7 oder 8, **dadurch gekennzeichnet, dass** die Auswertemittel (70) zum Auswerten des vom Mikrophon (60) erfassten Signals Mittel zum Verstärken, zum Logarithmieren und zum Gleichrichten des Signals aufweisen.

10. Verwendung des Verfahrens gemäß mindestens einem der Ansprüche 1 bis 6 und/oder des Wiedergabesystems (100) gemäß mindestens einem der Ansprüche 7 bis 9 für Audiosignale in mindestens einem Fortbewegungsmittel, insbesondere im Innenraum mindestens eines Kraftfahrzeugs.

## Claims

1. Method for setting at least the centre frequency of at least one filter unit (26) associated with a reproduction system (100) for audio signals, particularly a second-order recursive filter unit or a resonant filter unit which, in particular, is assigned to at least one digital equalizer (22, 24) associated with the reproduction system (100), which method involves
[a] first of all ascertaining the acoustic frequency response,
**characterized**
[b] **in that** a cutoff frequency for raising the bass level is then determined, below which the sound pressure undershoots a sound pressure threshold value related to the average sound pressure, and
[c] **in that** at least one filter parameter for the filter unit (26) is then automatically set such that the centre frequency of the filter unit (26) is just above the determined cutoff frequency.

2. Method according to Claim 1, **characterized in that** the acoustic frequency response is ascertained by virtue of
- at least one loudspeaker device (50) in the reproduction system (100) being successively actuated by bandpass noise signals having different centre frequencies, where the frequency bands respectively set in the form of at least one bandpass noise signal cover the entire audio spectrum, and
- the frequency response being ascertained in the form of frequency measurement points for the individual frequency bands, where the frequency measurement point determined for a particular frequency band is the sound level of the signal which is emitted by the loudspeaker device (50) in this case.

3. Method according to Claim 2, **characterized in that** the bandpass noise signals for ascertaining the acoustic frequency response are produced by means of the equalizer (22, 24) by virtue of
- the equalizer (22, 24) being supplied with at least one noise signal, and
- the filter parameter(s) for the filter unit (26) being set such that a bandpass characteristic with a narrow bandwidth at a prescribed centre frequency is obtained for the equalizer (22, 24).

4. Method according to at least one of Claims 1 to 3, **characterized in that** the average sound pressure is ascertained between method step [a] of ascertaining the acoustic frequency response and method step [b] of determining the cutoff frequency.

5. Method according to at least one of Claims 1 to 4, **characterized in that** before, during or after method step [c] the filter parameter(s) for the filter unit (26) is/are set such that the increase in bass level is reduced as the cutoff frequency rises or as the centre frequency of the filter unit (26) rises such that the isophones in the remaining reproducible bass frequency range are not exceeded.

6. Method according to at least one of Claims 1 to 5, where the filter parameter(s) is/are automatically set by means of at least two digital equalizers (22, 24), **characterized in that** the filter parameters for the individual equalizers (22, 24) are determined in succession by virtue of the previously set equalizer(s) (22, 24) being applied to the ascertained frequency response in each case before the filter parameters for an equalizer (22, 24) are determined.

7. Reproduction system (100) for audio signals which can be used to carry out a method according to at least one of Claims 1 to 6 by setting at least the centre frequency of at least one filter unit (26) associated with at least one digital equalizer (22, 24) in the reproduction system (100),
- having at least one loudspeaker device (50) and
- having at least one audio processor (20) which comprises the equalizer (22, 24) and which
-- is arranged in the signal path between at least one signal source (10, 12) and the loudspeaker device (50) and
-- is connected to at least one control processor (30) via at least one control bus (34),
**characterized**
- **in that** at least one noise generator (40) is provided which can be used to supply the equalizer (22, 24) with at least one noise signal,
- **in that** the control processor (30) has means which are used to set at least one filter parameter for the filter unit (26) such that the equalizer (22, 24) has a bandpass characteristic with a narrow bandwidth, the centre frequency being able to be varied over the audio spectrum,
- **in that** at least one microphone (60) having evaluation means (70) for detecting the signal emitted by the loudspeaker device (40) and for determining the frequency response is provided, and
- **in that** the control processor (30) has means which are used to set the at least one filter parameter while taking account of the measured frequency response.

8. Reproduction system according to Claim 7, **characterized in that** the noise generator (40) is
- implemented in the audio processor (20) and/or
- provided in the form of an additional external signal source.

9. Reproduction system according to Claim 7 or 8, **characterized in that** the evaluation means (70) for evaluating the signal detected by the microphone (60) have means for amplifying, logarithmizing and rectifying the signal.

10. Use of the method according to at least one of Claims 1 to 6 and/or the reproduction system (100) according to at least one of Claims 7 to 9 for audio signals in at least one means of locomotion, particularly in the interior of at least one motor vehicle.

## Revendications

1. Procédé de réglage au moins de la fréquence centrale d'au moins un filtre 26 associé à un système de reproduction 100 de signaux audio, notamment filtre récurant de second ordre ou filtre résonnant, cette fréquence étant notamment associée à au moins un égaliseur numérique 22, 24 associé au système de reproduction 100, selon lequel
a) on détermine tout d'abord la réponse en fréquence acoustique,
**caractérisé en ce que**
b) puis, on définit une fréquence limite pour relever le niveau des basses en dessous duquel la pression sonore passe en dessous d'un seuil de pression sonore rapporté à la pression sonore moyenne et
c) on règle au moins un paramètre du filtre 26 automatiquement pour que la fréquence centrale du filtre 26 se trouve juste au-dessus de la fréquence limite définie.

2. Procédé selon la revendication 1,
**caractérisé en ce qu'**
on détermine la réponse en fréquence acoustique
- en commandant au moins une installation de haut-parleur 50 du système de reproduction son, successivement avec des signaux de bruit de bande passante à des fréquences centrales différentes, les bandes de fréquences réglées chaque fois sous la forme d'au moins un signal de bruit de bande de fréquences couvrant l'ensemble du spectre audio, et
- en déterminant la réponse en fréquence sous la forme de points de mesure de fréquence des différentes bandes de fréquences, comme points de mesure de fréquences pour une certaine bande de fréquences, en définissant le niveau de bruit du signal émis dans ce cas par l'installation de haut-parleurs 50.

3. Procédé selon la revendication 2,
**caractérisé en ce qu'**
- on génère les signaux de bruit de bande passante pour déterminer la réponse en fréquence acoustique à l'aide de l'égaliseur 22, 24,
- on fournit au moins un signal de bruit à l'égaliseur 22, 24 et
- on règle le ou les paramètres du filtre 26 pour que l'égaliseur 22, 24, ait une caractéristique de bande passante de faible largeur pour une fréquence centrale prédéfinie.

4. Procédé selon au moins l'une des revendications 1 à 3,
**caractérisé en ce qu'**
on détermine la pression sonore moyenne entre l'étape a) du procédé consistant à déterminer la réponse en fréquence acoustique et l'étape de procédé b) consistant à déterminer la réponse en fréquence.

5. Procédé selon au moins l'une des revendications 1 à 4,
**caractérisé en ce qu'**
avant, pendant ou après l'étape de procédé c), on règle le ou les paramètres du filtre 26 pour que le relèvement du niveau des basses soit réduit avec l'augmentation de la fréquence limite ou avec l'augmentation de la fréquence centrale du filtre 26 pour que les isophones dans la plage de fréquences basses restantes, à reproduire, ne se chevauchent pas.

6. Procédé selon au moins l'une des revendications 1 à 5 dans lequel le ou les paramètres du filtre sont réglés automatiquement à l'aide d'au moins deux égaliseurs numériques 22, 24,
**caractérisé en ce qu'**
on définit successivement les paramètres de filtre des différents égaliseurs 22, 24 en appliquant aux égaliseurs réglés précédemment 24, 25, la réponse en fréquence déterminée chaque fois avant de déterminer le paramètre de filtre d'un égaliseur 22, 24.

7. Système de reproduction 100 de signaux audio mettant en oeuvre un procédé selon au moins l'une des revendications 1 à 6 en réglant au moins la fréquence centrale d'au moins un filtre 26 associé à au moins un égaliseur numérique 22, 24 du système de reproduction 100, ayant
- au moins une installation de haut-parleurs 50 et
- au moins un processeur audio 20 ayant l'un des égaliseurs 22, 24,
* ce processeur étant installé dans le chemin du signal entre au moins une source de signaux 10, 12 et l'installation de reproduction à haut-parleurs 50 et
* par au moins un bus de commande 34, il est relié à au moins un processeur de commande 30,
**caractérisé en ce qu'**
- il est prévu au moins un générateur de bruit 40 appliquant au moins un signal de bruit à l'égaliseur 22, 24,
- le processeur de commande 30 comporte des moyens par lesquels on règle au moins un paramètre de filtre 26 pour que l'égaliseur 22, 24 présente une caractéristique passe-bande à bande étroite, la fréquence centrale variant dans le spectre audio,
- au moins un micro 60 avec des moyens d'exploitation 70 pour recueillir les signaux émis par l'installation de haut-parleurs 40 et déterminer la réponse en fréquence et
- le processeur de commande 30 comporte des moyens pour régler au moins un paramètre de filtre en tenant compte de la réponse en fréquence, mesurée.

8. Système de reproduction selon la revendication 7,
**caractérisé en ce que**
le générateur de bruit 40
- est implémenté dans le processeur audio 20 et/ou
- est réalisé sous la forme d'une source supplémentaire de signaux externes.

9. Système de reproduction selon les revendications 7 ou 8,
**caractérisé en ce que**
les moyens d'exploitation 70 comportent des moyens d'amplification, de transformation logarithmique et d'équilibrage des signaux pour exploiter le signal saisi par le micro 60.

10. Utilisation du procédé selon l'une au moins des revendications 1 à 6 et/ou du système de reproduction 100 selon au moins l'une des revendications 7 à 9 pour des signaux audio dans au moins un moyen de transport, notamment dans l'habitacle d'au moins un véhicule.
